# EUROPÄISCHE PATENTSCHRIFT

(11) **EP 1 586 113 B1**
(45) Veröffentlichungstag und Bekanntmachung des Hinweises auf die Patenterteilung: **09.09.2009**
(21) Anmeldenummer: 03782474.5
(22) Anmeldetag: 22.12.2003
(51) Int. Cl.: H01L 21/225, H01L 21/266

(54) **VERFAHREN ZUM ERZEUGEN EINES DEFINIERTEN DOTIERUNGSGEBIETES IN EINEM HALBLEITERMATERIAL**
METHOD FOR PRODUCING A DEFINED DOPING REGION IN A SEMICONDUCTOR MATERIAL
PROCEDE DE PRODUCTION D'UNE ZONE DE DOPAGE DEFINIE DANS UN MATERIAU A SEMICONDUCTEURS

(30) Priorität: 23.01.2003 DE 10302632
(43) Veröffentlichungstag der Anmeldung: 19.10.2005
(73) Patentinhaber: austriamicrosystems AG, 8141 Unterpremstätten (AT)
(72) Erfinder: KNAIPP, Martin, A-8141 Unterpremstätten (AT)
(74) Vertreter: Epping - Hermann - Fischer
(86) Internationale Anmeldenummer: PCT/EP2003/014751
(87) Internationale Veröffentlichungsnummer: WO 2004/066373

(56) Entgegenhaltungen:
- US-A- 4 999 309
- US-B1- 6 376 321
- PATENT ABSTRACTS OF JAPAN vol. 1995, no. 06, 31. Juli 1995 (1995-07-31) -& JP 07 058213 A (OKI ELECTRIC IND CO LTD), 3. März 1995 (1995-03-03)

## Beschreibung

Die Erfindung betrifft ein Verfahren zum Erzeugen eines definierten Dotierungsgebiets in einem Halbleitermaterial, bei dem ein Dotierstoff mit Hilfe einer Maske in einen flächenmäßig begrenzten Oberflächenbereich des Halbleitermaterials implantiert wird und anschließend Eintreibbedingungen eingestellt werden, unter denen der Dotierstoff bis zu einer gewünschten Tiefe in das Halbleitermaterial eingetrieben wird.

Zur Herstellung von Dotierungen in Halbleitermaterialien sind Implantationsverfahren geeignet, bei denen die Implantationstiefe beispielsweise durch die kinetische Energie der zu implantierenden beispielsweise ionischen Dotierstoffe bestimmt wird. Alternativ und gegebenenfalls zusätzlich ist es möglich, einen implantierten Dotierstoff durch Einstellen geeigneter Eintreibbedingungen, insbesondere durch Fahren eines geeigneten Temperaturprogramms weiter in das Halbleitermaterial eindiffundieren zu lassen. Durch genaue Abstimmung von Implantationsverfahren und Eintreibbedingungen können auf diese Art und Weise unterschiedliche Dotierprofile hergestellt werden. Dabei gilt allgemein, daß die Form des Dotierprofils mit zunehmender Dotiertiefe schwerer zu kontrollieren ist und in der Regel zu dotierten Gebieten mit nicht optimalem Profil führt.

Bei elektronischen Bauelementen, die für einen Hochvolteinsatz bei beispielsweise 50V geeignet sind, ist die Einstellung optimaler Dotierprofile besonders wichtig, da unter dem Einfluß der hohen am Bauelement anliegenden Spannung besonders leicht elektrische Kurzschlüsse z.B. zum Substrat oder zu anderen Bauelementstrukturen hin auftreten können. Ein solches ungeeignetes Dotierprofil kann außerdem ebenfalls unerwünschte Ströme, z.B. aufgrund von Stoßionisation verursachen.

Zur elektrischen Isolierung von Transistorkontakten, insbesondere bei Hochvoltbauelementen, werden üblicherweise ineinander angeordnete Wannen entgegengesetzter Leitfähigkeit eingesetzt, so daß an den Übergängen eines mit einem Dotierstoff eines ersten Leitfähigkeitstyps dotierten Anschlußgebiets zur isolierenden Wanne, die mit einem Dotierstoff eines zweiten Leitfähigkeitstyps dotiert ist, sowie am Übergang von der isolierenden Wanne hin zum Substrat, welches wiederum mit einem Dotierstoff des ersten Leitfähigkeitstyps dotiert ist, zusätzliche Raumladungszonen entstehen, die Ladungsträgerbarrieren darstellen.

In der Prozeßentwicklung bei der Herstellung und Prozessierung solcher Hochvoltbauelemente ist es ein ausdrückliches Ziel, die Bauelemente mit definierten Durchbruchsspannungen und geringen Schaltwiderständen zu realisieren. Dazu ist es insbesondere notwendig, die Raumladungszonen in dem Bauelement bezüglich der geforderten elektrischen Kenngrößen zu optimieren. Da diese jedoch dreidimensionale Abmessungen haben, ist auch eine dreidimensionale Kontrolle der Raumladungszonen und insbesondere eine Kontrolle des dreidimensionalen Dotierprofils erforderlich. Dies gilt insbesondere bei der Herstellung isolierender Wannen, sogenannter PTUBs oder NTUBs. Solche Wannen müssen in eine Tiefe von bis zu 10 µm eingetrieben werden. Die Breite einer solchen Wanne kann dabei je nach Bauelement von 2 bis 20 µm betragen.

Ganz allgemein entsteht aus einem z.B. ursprünglich punktförmigen implantierten Gebiet durch gleichmäßiges Eintreiben in den Halbleiter hinein ein nahezu sphärisches dotiertes Gebiet mit dem ursprünglichen Implantationsgebiet als Zentrum. Zur Herstellung größerer dotierter Zonen werden Implantationsmasken mit entsprechend großen Öffnungen verwendet. Beim Eintreiben aus solchen großflächigen Implantationsgebieten überlagern sich in erster Näherung sphärische Diffusionsgebiete aus entsprechend vielen gedachten punktförmigen Diffusionsquellen bzw. Implantationsgebieten. Dabei wird nur im Zentrum des so erzeugten dotierten Gebiets ein eindimensionales Dotierprofil erhalten, nicht aber am Rand, da die äußere Begrenzung der Maske zu zylindrisch oder sphärisch verlaufenden Isokonzentrationslinien des dotierten Gebietes führt. Daher weist das Dotierprofil eines so erzeugten Gebietes einen nicht optimierten Verlauf zwischen den Randzonen und den zentralen Zonen auf.

Das Dokument PATENT ABSTRACTS OF JAPAN Bd. 1995, Nr. 06, 31. Juli 1995 (1995-07-31) -& JP 07 058213 A (OKI ELECTRIC IND CO LTD), 3. März 1995 (1995-03-03) offenbart ein Verfahren zur Herstellung einer dotierten Wanne. Um eine homogene Wannentiefe zu erreichen, wird die Wanne durch das Zusammenwachsen von mehreren implantierten Gebieten gebildet.

Aufgabe der vorliegenden Erfindung ist es daher, ein Dotierverfahren anzugeben, mit dem ein dotiertes Gebiet mit einem besser geeigneten gleichmäßigen Dotierprofil erzeugt werden kann.

Diese Aufgabe wird mit einem Verfahren der eingangs genannten Art mit Hilfe der kennzeichnenden Merkmale von Anspruch 1 gelöst.

Vorteilhafte Ausgestaltungen des Verfahrens sind weiteren Ansprüchen zu entnehmen.

Während bisher in bekannten Dotierverfahren bei der Implantation Masken verwendet werden, die eine dem zu erzeugenden dotierten Gebiet entsprechende Öffnung aufweisen, schlägt die Erfindung nun die Verwendung einer Maske vor, die eine für Dotierstoff durchlässige Zone aufweist, die ringförmig geschlossen um eine für Dotierstoff unzulässige Zone angeordnet ist. Mithin wird mit dieser Maske zunächst ein ringförmiges implantiertes Gebiet erzeugt. Nach Einstellen von Eintreibbedingungen zum Eintreiben des Dotierstoffes diffundiert der Dotierstoff gleichmäßig in alle Richtungen, also auch unter den undurchlässigen Maskenbereich, wobei sich die ringförmigen Diffusionsfronten unterhalb dieses undurchlässigen Maskenbereiches schließen bzw. vereinigen.

Auf diese Weise wird ein dotiertes Gebiet erzeugt, das über den entscheidenden Bereich ein äußerst gleichmäßiges Dotierprofil aufweist, welches wesentlich geringere Unterschiede in der Dotierkonzentration zwischen Randbereichen und zentralen Bereichen aufweist und insbesondere in den Randbereichen besser für die verlangten Anforderungen optimiert ist.

Der für den Dotierstoff durchlässige Maskenbereich definiert den späteren dotierten Bereich und besitzt daher im Wesentlichen die gleiche Form bei einer entsprechend angepaßten Dimension. Es wird mit Hilfe des durchlässigen Maskenbereiches ein rechteckiges zu erzeugendes Dotiergebiet definiert.

Bei der Erzeugung von dotierten Gebieten mit rechteckiger Grundfläche ist die Breite des ringförmig geschlossenen, für Dotierstoff durchlässigen Maskenbereichs, in Abhängigkeit von der Ausrichtung zu den beiden Ortskoordinatenachsen unterschiedlich zu gestalten. Die Breite des durchlässigen Bereichs an den Stirnseiten des zu dotierenden rechteckigen Gebietes wird anders gestalten als die Breite der entsprechenden durchlässigen Bereiche entlang der Längsseiten des Rechtecks.

Es ist möglich, insbesondere bei größeren herzustellenden dotierten Gebieten im inneren des undurchlässigen Maskenbereiches weitere durchlässige Bereiche vorzusehen, die als flächige Öffnungen oder ebenfalls als ringförmige Öffnungen ausgebildet sein können. Auf diese Weise wird das dotierte Gebiet durch Überlagerung mehrerer von innen nach außen und von außen nach innen verlaufender Diffusionsfronten erzeugt. So kann insbesondere bei größeren zu dotierenden Flächen die Einstellung eines gleichmäßigen Dotierprofils unterstützt werden.

Wird das erfindungsgemäße Verfahren zur Herstellung von isolierenden Wannen, sogenannter PTUBs, NTUBs, PWLLs oder NWELLsfür Hochvoltbauelemente verwendet, so werden die Eintreibbedingungen vorzugsweise so gewählt, daß der Dotierstoff bis zu einer Tiefe von ca. 10 µm in den Halbleiter getrieben wird.

Bei geeigneter Wahl der Maskendimensionen, insbesondere bei geeigneter Einstellung von Breite der ringförmigen, für Dotierstoff durchlässigen Gebiete und Gesamtbreite des zu dotierenden Gebietes relativ zueinander bilden sich auf diese Weise zwei Dotierstoffgrenzverläufe aus, welche über die gesamte Fläche des dotierten Gebietes nahezu parallel zur Waferoberfläche bzw. parallel zur Oberfläche des Halbleitersubstrats verlaufen.

Im folgenden wird die Erfindung anhand eines Ausführungsbeispiels und der dazugehörigen Figuren näher erläutert.
- Figur 1: zeigt im schematischen Querschnitt eine herkömmlich erzeugte dotierte Zone unter einer zur Dotierung verwendeten Maske,
- Figur 2: zeigt verschiedene Verfahrensstufen bei der erfindungsgemäß Herstellung eines dotierten Gebietes,
- Figur 3: zeigt eine erfindungsgemäß verwendete Maske in der Draufsicht,
- Figur 4: zeigt im schematischen Querschnitt ein Bauelement mit erfindungsgemäß erzeugter isolierender Wanne.

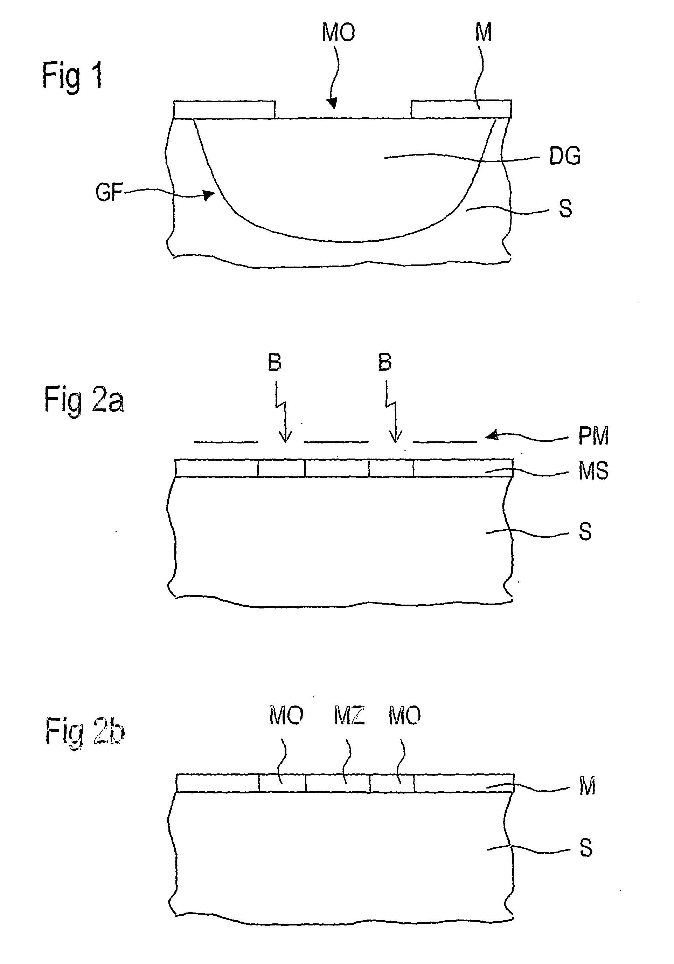

Figur 1 zeigt ein mit bekannten Dotierverfahren erzeugtes dotiertes Gebiet mit einem traditionellen Dotierstoffgrenzverlauf. Zur Herstellung eines dotierten Gebietes DG in einem Substrat S wird zunächst eine Maske M erzeugt, beispielsweise eine photolithographisch strukturierte Lackmaske. Die Maske weist Öffnungen MO auf, die bei der Implantation eines Dotierstoffs für diesen durchlässig sind. Die von der Maske M bedeckten Bereiche sind die für den Dotierstoff undurchlässige Maskenbereiche. Nach Implantation eines Dotierstoffs im Bereich der Maskenöffnung MO und anschließendem Eintreiben des Dotierstoffs bei erhöhter Temperatur bildet sich ein dotiertes Gebiet DG aus, welches im Wesentlichen eine sphärische Ausdehnung rund um die im Verhältnis zur Eintreibtiefe kleinen Maskenöffnung MO aufweist. Die Grenzfläche GF zum Substrat S, welches üblicherweise eine zum dotierten Gebiet DG entgegengesetzte Dotierung aufweist, verläuft nur in einem eng begrenzten Gebiet nahezu parallel zur Oberfläche des Substrats S.

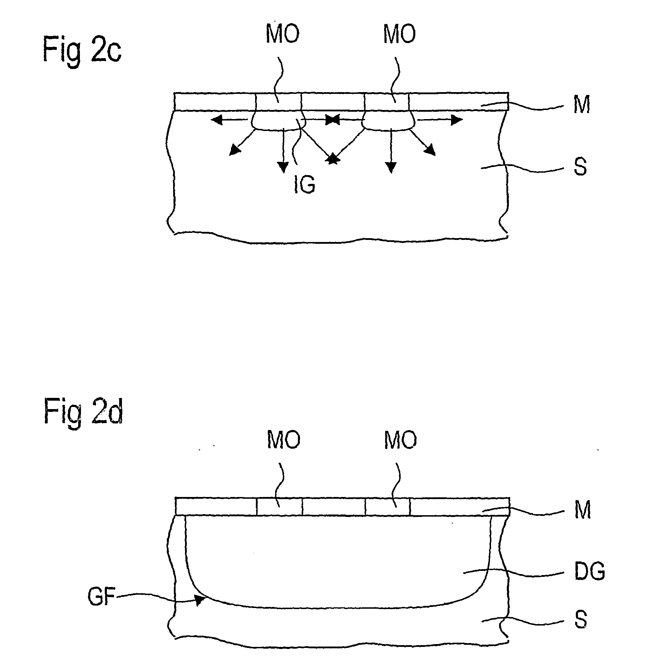

Figur 2 zeigt mehrere Verfahrensstufen bei der erfindungsgemäßen Herstellung eines definierten Dotierungsgebiets anhand schematischer Querschnitte.

Figur 2a zeigt die Herstellung einer für die Implantation verwendbaren Maske M. Dazu wird zunächst auf einem Substrat S, welches mit einem Dotierstoff eines ersten Leitfähigkeitstyp dotiert ist, eine ganzflächige Maskenschicht MS aufgebracht und mit Hilfe einer Fotomaske PM belichtet. Zur Belichtung B kann eine beliebige elektromagnetische oder ionisierende Bestrahlung B verwendet werden. Dadurch werden in der Maskenschicht MS Bereiche erzeugt, die gegenüber der ursprünglichen Maskenschicht eine veränderte Eigenschaften, z.B. eine veränderte Löslichkeit gegenüber einem Entwickler aufweisen.

Figur 2b zeigt die Anordnung nach der Entwicklung, die z.B. mittels eines Lösungsmittels, einer Ätzlösung oder auch durch Plasmaätzen erfolgen kann. Die nach Entwicklung von der Maskenschicht MS verbleibenden Maskenbereiche M sind für den Dotierstoff undurchlässig. Die Maskenöffnungen MO dagegen sind für den Dotierstoff durchlässige Maskenbereiche. Die durchlässigen Maskenbereiche MO bilden eine ringförmig um den zentralen Maskenbereich MZ geschlossene Zone.

Anhand der Figuren 2a und 2b ist die Erzeugung einer Implantations-Maske mit Hilfe eines Positiv-Fotolacks beschrieben. Möglich ist es jedoch auch, die Maske mit Hilfe eines negativ arbeitenden Fotolacks zu erzeugen, bei der die durch Bestrahlung in ihren Eigenschaften veränderten Bereiche nach der Entwicklung stehen bleiben. Dies erfordert eine mit invertierter Struktur ausgebildete Foto-Maske PM, die einem Negativbild der in Figur 2a dargestellten Foto-Maske PM entspricht.

Im nächsten Schritt wird ein Dotierstoff eines zweiten Leitfähigkeitstyps in die Substratoberfläche implantiert. Dabei entstehen implantierte Gebiete IG im Bereich unterhalb der Maskenöffnungen MO. Figur 2c zeigt die Anordnung nach dieser Verfahrensstufe. Anschließend werden Eintreibbedingungen eingestellt, die das Eindiffundieren des in den implantierten Gebieten IG konzentrierten Dotierstoffs unterstützen. Dadurch setzt eine Diffusion des Dotierstoffs gleichmäßig nach allen Seiten in das Substrat hinein ein, wie es in der Figur 2c durch entsprechende Pfeile angedeutet ist. Das Eintreiben wird solange fortgesetzt, bis ein dotiertes Gebiet entstanden, das bis zu einer gewünschten Tiefe unter die Substratoberfläche reicht.

Figur 2d zeigt das erfindungsgemäß hergestellte dotierte Gebiet DG. Gut zu erkennen ist, daß das dotierte Gebiet DG über einen großen Bereich hin eine zur Oberfläche des Substrats S parallele Grenzfläche GF zum Substrat hin aufweist. Da sich zwischen Substrat und entgegengesetzt dotiertem Gebiet DG eine Raumladungszone einstellt, verläuft auch diese über große Bereiche parallel zur Oberfläche des Substrats. Verglichen mit der sphärischen Ausdehnung eines nach bekanntem Verfahren hergestellten dotierten Gebietes, wie z. B. in Figur 1 dargestellt, wird der Vorteil des erfindungsgemäßen Verfahrens deutlich.

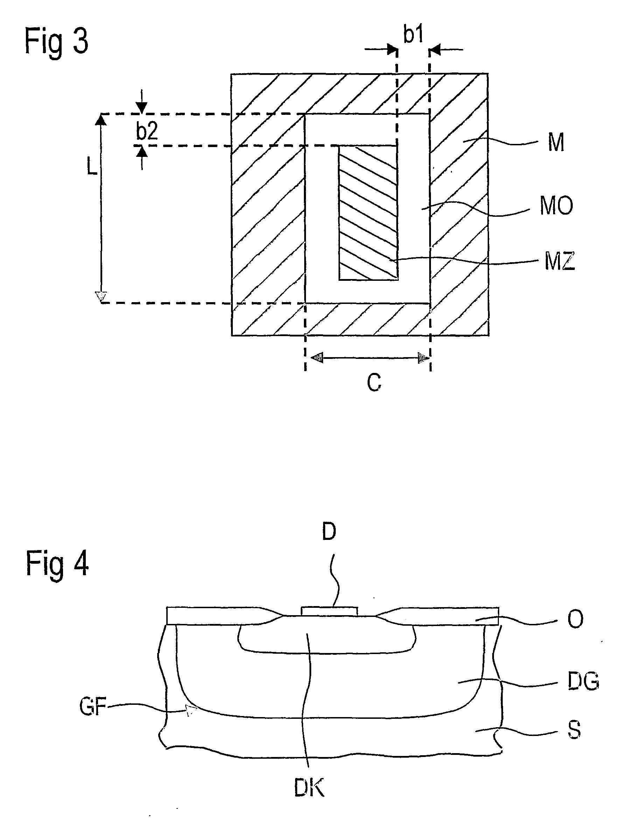

Figur 3 zeigt wie eine erfindungsgemäß verwendete Maske geometrisch ausgebildet ist. Diese Maske ist zur Herstellung eines in der Grundfläche rechteckigen dotierten Gebietes geeignet. Die Maskenöffnung MO umschließt einen für Dotierstoff undurchlässigen zentralen Maskenbereich MZ von ebenfalls rechteckiger Grundfläche. Die so ringförmig geschlossene, rechteckig ausgebildete Maskenöffnung MO weist im gewählten Ausführungsbeispiel im gesamten Umfang die gleiche Breite b auf. In anderen Fällen, insbesondere wenn die Längendimensionen L wesentlich größer als der dazu senkrechte Durchmesser c der Maskenöffnung MO ist, kann die Breite b2 der Maskenöffnung an den Stirnseiten des Rechtecks einen anderen Wert annehmen, als die Breite b1 an den Längsseiten des Rechtecks. Die Dicke der Implantations-Maske MS beträgt beispielsweise 1-2 µm.

Ein erfindungsgemäß erzeugtes dotiertes Gebiet DG kann z. B. als isolierende Wanne rund um den Anschlußkontakt eines MOS-Transistors verwendet werden, wie dies z.B. anhand der in Figur 4 dargestellten schematischen Querschnittszeichnung ersichtlich ist. Beispielsweise kann das dotierte Gebiet DG unter Verwendung von Phosphor als Dotierstoff als NWELL unterhalb des Drain-Anschlusses D eines MOS-Transistors verwendet werden. Direkt unter dem Drainkontakt des Transistors wird anschließend eine für den Anschluß geeignete Leitfähigkeit durch Dotierung eines Gebiets DK mit einem Dotierstoff vom ersten Leitfähigkeitstyp erzeugt, die wie im in Figur 4 dargestellten Ausführungsbeispiel als sogenannte PTUB ausgebildet ist. Diese weist eine p-Dotierung (Bor) auf und bildet zur NWELL einen Halbleiterübergang aus. Aus der in Figur 4 dargestellten schematischen Querschnittszeichnung ist gut erkennbar, daß die Phasengrenzen der PTUB zur NWELL und die NWELL zum Substrat weitgehend parallel zueinander verlaufen. Dies garantiert, daß überall gleichmäßige Durchbruchsbedingungen herrschen und damit die Durchbruchspannung exakt eingestellt werden kann. Beiderseits des Drainkontakts D ist dieser von Feldoxidisolationen O auf der Oberfläche des Substrats S begrenzt. Für ein solches Bauelement wird beispielsweise eine Maske mit folgenden Designgrößen verwendet. Der Durchmesser c der Maskenöffnung MO wird auf einen Wert von 2 bis 20 µm eingestellt. Die Breiten b1, b2 der Maskenöffnung MO werden auf einen Wert eingestellt, der zwischen 5 µm und der kleinsten prozeßtechnisch herstellbaren Breite variiert. Die Länge L der Maskenöffnung MO korrespondiert mit der Transistorweite und ist ein skalierbarer Parameter.

Mit dem erfindungsgemäßen Verfahren und der dazu verwendeten neuartigen Maske läßt sich unterhalb des Anschlußkontakts, beispielsweise des Drainkontakts, die Durchbruchspannung zwischen dem dotierten Gebiet DG und dem Substrat und damit auch zwischen der PTUB unter dem Drainkontakt und dem Substrat erhöhen. Der geringe Abstand der Außenkante der PTUB und dem Übergang zwischen NWELL und Substrat kann in einem störungssicheren Prozeß mit höherer Genauigkeit garantiert werden. Dies ist möglich, da der Abstand der Dotierstoffgrenzverläufe eine gleichmäßige Entfernung aufweisen, was mit einer herkömmlichen ganzflächigen Maskenöffnung nicht der Fall ist.

## Patentansprüche

1. Verfahren zum Erzeugen eines definierten Dotierungsgebiets (DG) in einem Halbleitermaterial (S),
bei dem ein Dotierstoff mit Hilfe einer Maske (M, MO) in einen flächenmäßig begrenzten Oberflächenbereich des Halbleitermaterials implantiert wird,
bei dem anschließend Eintreibbedingungen eingestellt werden, unter denen der Dotierstoff bis zu einer gewünschten Tiefe in das Halbleitermaterial eingetrieben wird,
**dadurch gekennzeichnet,**
- **daß** für die Implantation eine Maske verwendet wird, die einen für den Dotierstoff durchlässigen Maskenbereich (MO) aufweist, der ringförmig geschlossen um einen für den Dotierstoff undurchlässigen zentralen Maskenbereich (MZ) angeordnet ist, wobei der durchlässige und der undurchlässige zentrale Maskenbereich rechteckig sind und sich die Breite des durchlässigen Maskenbereichs an den Stirnseiten des Rechtecks von der Breite an den Längsseiten unterscheidet,
- **daß** zunächst ein ringförmiges implantiertes Gebiet erzeugt wird,
- **daß** sich unter den Eintreibbedingungen ringförmige Diffusionsfronten ausbilden und sich unterhalb des undurchlässigen Maskenbereiches vereinigen, wobei ein dotiertes Gebiet mit gleichmäßigem Dotierprofil erzeugt wird.

2. Verfahren nach Anspruch 1,
bei dem der Dotierstoff bis in eine Tiefe von 10 µm getrieben wird.

3. Verfahren nach einem der vorangehenden Ansprüche,
bei dem der Durchmesser des undurchlässigen Maskenbereichs (MZ), die Breite b des durchlässigen Maskenbereichs (MO) und die Eintreibbedingungen so aufeinander abgestimmt werden, daß die untere Grenze des erzeugten Dotierungsgebiet (DG) weitgehend einen konstanten Abstand zur Oberfläche des Halbleitermaterials (S) aufweist.

4. Verfahren nach einem der Ansprüche 1 bis 3,
bei dem zur Erzeugung einer isolierenden Wanne in ein Substrat (S) vom ersten Leitfähigkeitstyp ein Dotierstoff eines zweiten Leitfähigkeitstyps implantiert und eingetrieben wird, wobei ein definiertes Dotierungsgebiet (DG) des zweiten Leitfähigkeitstyps erzeugt wird.

5. Verfahren nach Anspruch 4,
bei dem zur Erzeugung einer N-Wanne oder NTUB ein Phosphor haltiger Dotierstoff in ein p-leitendes Substrat (S) implantiert und eingetrieben wird.

6. Verfahren nach einem der Ansprüche 4 oder 5,
bei dem zur Erzeugung einer isolierenden Wanne eines ersten Leitfähigkeitstyps im Draingebiet eines MOS Transistors ein implantiertes Gebiet (IG) mit einer parallel zur Stromflußrichtung des Transistors bemessenen Breite von 2 bis 20 µm erzeugt wird, wobei die dazu verwendete Maske (M, MO) einen entsprechenden Durchmesser aufweist.

7. Verfahren nach einem der Ansprüche 1 bis 6,
bei dem die Maske (M, MO) als Lackmaske auf dem Substrat photolithographisch erzeugt wird.

## Claims

1. A method for producing a defined doping zone (DG) in a semiconductor material (S),
wherein a doping agent is implanted by means of a mask (M, MO) in a surface region of the semiconductor material which has a confined area,
wherein introducing conditions are subsequently set under which the doping agent is driven into the semiconductor material to a desired depth,
**characterized in that**
- a mask having a mask area (MO) which is permeable to the doping agent and is arranged in a closed ring shape around a central mask area (MZ) which is impermeable to the doping agent is used for the implantation, the permeable mask area and the impermeable central mask area being rectangular and the width of the permeable mask area on the front sides of the rectangle differing from the width on the longitudinal sides,
- a ring-shaped implanted zone is produced initially,
- ring-shaped diffusion fronts are formed under the introducing conditions and merge underneath the impermeable mask area, a doped zone with a uniform doping profile being produced.

2. The method according to claim 1,
wherein the doping agent is introduced up to a depth of 10 µm.

3. The method according to any of the preceding claims,
wherein the diameter of the impermeable mask area (MZ), the width b of the permeable mask area (MO) and the introducing conditions are adapted to each other such that the lower boundary of the produced doping zone (DG) substantially has a constant distance to the surface of the semiconductor material (S).

4. The method according to any of the claims 1 to 3,
wherein a doping agent of a second conductive type is implanted and introduced into a substrate (S) of the first conductive type for producing an insulating well, producing a defined doping area (DG) of the second conductive type.

5. The method according to claim 4,
wherein a phosphor-containing doping agent is implanted and introduced into a p-conductive substrate (S) for producing a N-well or NTUB.

6. The method according to any of the claims 4 or 5,
wherein an implanted zone (IG) with a width of 2 to 20 µm measured parallel to the direction of the current flow of the transistor is produced for producing an insulating well of a first conductive type in the drain zone of a MOS transistor, the mask (M, MO) being used for this purpose having a corresponding diameter.

7. The method according to any of the claims 1 to 6,
wherein the mask (M, MO) is produced as a resist mask on the substrate by means of photolithographic technology.

## Revendications

1. Procédé de production d'une zone de dopage définie (DG) dans un matériau semi-conducteur (S),
dans lequel un agent dopant est implanté à l'aide d'un masque (M, MO) dans une zone de surface limitée en superficie du matériau semi-conducteur,
dans lequel sont ensuite réglées des conditions d'enfoncement dans lesquelles l'agent dopant est enfoncé jusqu'à une profondeur souhaitée dans le matériau semi-conducteur,
**caractérisé en ce que**
- l'implantation est réalisée à l'aide d'un masque qui présente une zone de masque (MO) perméable à l'agent dopant, laquelle est disposée en une forme annulaire fermée autour d'une zone de masque centrale (MZ) imperméable à l'agent dopant, la zone de masque perméable et la zone de masque centrale imperméable étant rectangulaires et la largeur de la zone de masque perméable sur les petits côtés du rectangle différant de la largeur sur les grands côtés,
- une zone implantée de forme annulaire est produite dans un premier temps,
- des fronts de diffusion de forme annulaire se constituent dans les conditions d'enfoncement et s'unissent sous la zone de masque imperméable, une zone dopée présentant un profil de dopage homogène étant produite.

2. Procédé selon la revendication 1,
dans lequel l'agent dopant est enfoncé jusqu'à une profondeur de 10 µm.

3. Procédé selon l'une des revendications précédentes,
dans lequel le diamètre de la zone de masque imperméable (MZ), la largeur b de la zone de masque perméable (MO) et les conditions d'enfoncement sont accordés entre eux de telle manière que la limite inférieure de la zone de dopage produite (DG) présente dans une large mesure un écart constant par rapport à la surface du matériau semi-conducteur (S).

4. Procédé selon l'une des revendications 1 à 3,
dans lequel, en vue de la production d'une cuvette isolante, un agent dopant d'un second type de conductibilité est implanté et enfoncé dans un substrat (S) du premier type de conductibilité, une zone de dopage définie (DG) du second type de conductibilité étant produite.

5. Procédé selon la revendication 4,
dans lequel, en vue de la production d'une cuvette N ou NTUB, un agent dopant phosphoré est implanté et enfoncé dans un substrat (S) de conductivité p.

6. Procédé selon l'une des revendications 4 ou 5,
dans lequel, en vue de la production d'une cuvette isolante d'un premier type de conductibilité dans la zone de drainage d'un transistor MOS, une zone implantée (IG) est produite avec une largeur dimensionnée entre 2 et 20 µm parallèlement au sens de conduction du courant du transistor, le masque utilisé à cet effet (M, MO) présentant un diamètre adapté en conséquence.

7. Procédé selon l'une des revendications 1 à 6,
dans lequel le masque (M, MO) est produit photolithographiquement comme masque en vernis sur le substrat.
